# EUROPÄISCHE PATENTSCHRIFT

(11) **EP 4 466 547 B1**
(45) Veröffentlichungstag und Bekanntmachung des Hinweises auf die Patenterteilung: **24.12.2025**
(21) Anmeldenummer: 23719749.6
(22) Anmeldetag: 14.04.2023
(51) Int. Cl.: G01R 31/12, G01R 31/14, G01R 31/34

(54) **SENSORSYSTEM FÜR EINE ELEKTRISCHE MASCHINE**
SENSOR SYSTEM FOR AN ELECTRIC MACHINE
SYSTÈME DE CAPTEUR POUR UNE MACHINE ÉLECTRIQUE

(30) Priorität: 27.04.2022 EP 22170171
(43) Veröffentlichungstag der Anmeldung: 27.11.2024
(73) Patentinhaber: Siemens Aktiengesellschaft, 80333 München (DE)
(72) Erfinder: KATZENBERGER, Tobias, 97631 Bad Königshofen STT Untereßfeld (DE); PLOCHMANN, Bastian, 91413 Neustadt an der Aisch (DE)
(74) Vertreter: Siemens Patent Attorneys
(86) Internationale Anmeldenummer: PCT/EP2023/059803
(87) Internationale Veröffentlichungsnummer: WO 2023/208616

(56) Entgegenhaltungen:
- EP-A1- 2 857 852
- EP-A1- 3 715 883
- DE-A1- 102019 104 741
- DE-T2- 60 025 927
- US-A1- 2011 316 691
- US-B1- 6 297 742
- ANONYMOUS: "Heat Sensor Circuit Diagram", 12 November 2012 (2012-11-12), pages 1 - 3, XP055968776, Retrieved from the Internet <URL:https://www.circuitstune.com/2012/11/heat-sensor-circuit.html> [retrieved on 20221006]

## Beschreibung

Der Gegenstand der vorliegenden Offenbarung ist ein Sensorsystem für eine elektrische, vorzugsweise rotatorische Maschine umfassend eine Sensor-Sender-Vorrichtung und eine vorzugsweise autarke Sensor-Empfänger-Vorrichtung, wobei die Sensor-Sender-Vorrichtung und die Sensor-Empfänger-Vorrichtung außen an der Maschine anbringbar sind, wobei die Sensor-Sender-Vorrichtung dazu ausgebildet ist, zumindest eine physikalische, mit der Maschine assoziierte Messgröße zu erfassen und, wenn die Messgröße einen vorbestimmten Schwellenwert überschreitet, zumindest ein mit der Messgröße assoziiertes Signal auszusenden, wobei die Sensor-Empfänger-Vorrichtung dazu eingerichtet ist, das Signal zu empfangen und die Überschreitung des Schwellenwerts zu melden.

Außerdem ist der Gegenstand der vorliegenden Offenbarung eine elektrische Maschine mit einem solchen Sensorsystem.

Im Niederspannungs-Industriemotorenbereich ist das Isoliersystem definitionsgemäß teilentladungsfrei und kosteneffizient ausgelegt. Die zunehmende Nutzung von Umrichtern zum Ansteuern dieser Motoren bewirkt allerdings, dass aufgrund der steilen Schaltflanken der Umrichter und der undefiniert langen Leitungslängen im Stromnetz Überspannungspulse im Netz vorhanden sein können, welche im oben angesprochenen kosteneffizient ausgeführten Isoliersystem (günstige Materialien, günstige Prozesse, Fehlstellen nicht ausgeschlossen) zu Teilentladungen führen können. Diese Teilentladungen bewirken eine rasche Degradation des Isoliersystems und somit eine deutlich verringerte Lebensdauer, wenn es zwangsläufig zum elektrischen Durchschlag kommt.

Grundsätzlich sind Systeme zur Detektion von Teilentladungen als solchen bekannt (siehe z.B. EP 3 715 883 A1, DE 600 25 927 T2, EP 2 857 852 A1).

Der Ausfall der Maschine kann aktuell nur prognostiziert werden, indem aktive Messungen und Untersuchungen des Isoliersystems durch einen Techniker vor Ort geschehen, was in diesem Preissegment nicht wirtschaftlich und üblich ist. Eine *in-situ* Messung und online-Rückkopplung ist besonders im Preissegment dieser kleineren Motoren nicht wirtschaftlich, da die gängigen Mess- und Prüfsysteme sowie die Schnittstellen zu einem Cloud-Dienst die Herstellungskosten und damit den Marktpreis der Motoren signifikant und unrealistisch erhöhen würden. Ein Motorenhersteller und -lieferant kann die Beanspruchung, die beim Benutzer vorliegt, nicht vorhersehen und hat damit aktuell keine Möglichkeit die Lebensdauer der Maschine und einen möglichen Ausfall zu prognostizieren ("Predicitive Maintenance"). Ebenso kann dem Benutzer keine Überspannung und damit fehlerhafte Handhabung nachgewiesen werden, wodurch innerhalb der Garantie / Gewährleistung Ersatzkosten entstehen und darüber hinaus das Image beschädigt werden kann, wenn die gelieferten Produkte vorzeitig, innerhalb kurzer Zeit ausfallen.

Somit ist es wünschenswert, dass der Zustand der Antriebskomponenten der Motoren permanent erfasst und kommuniziert wird. Dazu lassen sich Motoren und Umrichter mit entsprechenden Konnektivitätsmodulen ausrüsten (siehe **z.B.** US 6 297 742 B1, DE 10 2019 104 741 A1, US 2011/316691 A1). In diesem Umfeld sind Module bekannt, die alle relevanten Betriebs- und Zustandsdaten einer Antriebskomponente per Sensorik, sowie einen Temperaturmesser erfassen und diese Daten an ein offenes IoT-Betriebssystem übermitteln können.

Solche Module sind bewusst kostengünstig, ohne direkte Verbindung zum Motor ausgelegt und können ebenso auf bestehende Motoren appliziert werden (Aufkleben auf das Gehäuse, ohne Kabelverbindung). Die Sensorik wird mittels einer Batteriezelle betrieben. Diese Lösung bietet die erste Möglichkeit physikalische Parameter des Motors (mechanische/akustische Veränderungen der Lager, Temperaturerhöhungen am Gehäuse) *in-situ* aufzuzeichnen und zu Predictive-Maintenance-Zwecken online zu spiegeln.

Die Schwachstelle ist hierbei, dass die Parameter extern aufgezeichnet werden, d.h. erst sekundäre Effekte, wie Erhöhung der Gehäusetemperatur oder akustische Veränderungen der Lager aufgrund Degradation der Schmierstoffe durch Lagerströme detektiert werden können. Primäre Messgrößen, wie Wicklungstemperatur, TE-Aktivität (TE für Teilentladungen) oder elektrische/kapazitive Veränderungen in der Motorenschaltung können aufgrund der aus Kostengründen fehlenden physikalischen Ankopplung nicht erfasst werden.

Die der vorliegenden Erfindung zugrunde liegende Aufgabe besteht darin, ein kostengünstiges Sensorsystem bereitzustellen, das die vorgenannten Nachteile behebt und eine zuverlässige Erfassung der Überspannungen an der elektrischen Maschine ermöglicht.

Die Aufgabe wird mit einem eingangs genannten Sensorsystem dadurch gelöst, dass die Sensor-Sender-Vorrichtung dazu ausgebildet ist, in einem Stromanschlussbereich der elektrischen Maschine angeordnet zu werden, und die Sensor-Empfänger-Vorrichtung dazu eingerichtet ist, außen an der Maschine befestigt zu werden, wobei die zumindest eine physikalische Messgröße Spannung ist, und die Sensor-Sender-Vorrichtung ausgebildet ist, Überspannungen in der elektrischen Maschine zu erfassen, wobei die Sensor-Sender-Vorrichtung eine Schaltung umfasst, wobei die Schaltung einen Widerstand umfasst, wobei der Widerstand eine Schicht umfasst, die derart ausgebildet ist, dass bei den Überspannungen in der elektrischen Maschine Teilentladungen in der Schicht auftreten, wodurch sich der Wert des Widerstands vergrößert.

Mit anderen Worten sendet die Sensor-Sender-Vorrichtung das Signal dann aus, wenn der Wert des Widerstands einen vorbestimmten Schwellenwert übersteigt.

Die Sensor-Sender-Vorrichtung ist vorzugsweise dazu ausgebildet, die physikalische, mit der Maschine assoziierte Messgröße unmittelbar bzw. direkt zu erfassen bzw. zu messen. Insofern misst die Sensor-Sender-Vorrichtung direkt interne Messgrößen der Maschine bzw. erfasst die primären Effekte. Mit anderen Worten, die Sensor-Sender-Vorrichtung ist derart an die Maschine anbindbar, dass eine direkte physikalische Verbindung zwischen der Sensor-Sender-Vorrichtung und der Maschine hergestellt werden kann und durch diese direkte/unmittelbare physikalische Verbindung die physikalische Größe erfasst werden kann (z.B. Anbindung an Spannung, um Spannung zu erfassen, an einen Temperaturfühler, um Temperatur zu erfassen, etc.).

Die Sensor-Empfänger-Vorrichtung kann insofern autark sein, als sie nicht kabelgebunden ist und somit keinen externen Stromanschluss (wird beispielsweise von einer Batterie betrieben) braucht, um ohne direkte physikalische Verbindung Messgrößen aufzuzeichnen.

Bei einer Ausführungsform kann es vorgesehen sein, dass die Sensor-Empfänger-Vorrichtung dazu ausgebildet und/oder konfiguriert ist, akustische Signale zu detektieren, die beispielsweise auf mechanische Schwingungen eines Rotors der Maschine zurückzuführen sind und beispielsweise abhängig von einer Frequenz und/oder des Musters dieser akustischen Signale den Zustand des Lagers zu bestimmen. Dadurch kann die Sensor-Empfänger-Vorrichtung beispielsweise akustische Veränderungen der Lager aufgrund Degradation der Schmierstoffe durch Lagerströme detektieren. Die Sensor-Empfänger-Vorrichtung detektiert somit sekundäre Effekte. Im Allgemeinen kann die Sensor-Empfänger-Vorrichtung dazu ausgebildet und/oder konfiguriert sein, mechanische Schwingungen, z.B. Vibrationen etc. von der Maschine zu erfassen und diese (z.B. nach Frequenz) zu interpretieren.

Das von der Sensor-Sender-Vorrichtung ausgesandte Signal ist ereignisgetriggert. Das Signal ist insofern mit der erfassten Messgröße assoziiert, als es nur dann ausgesandt wird, wenn der vorgenannte Schwellenwert überschritten wird.

Die Sensor-Empfänger-Vorrichtung ist dazu ausgebildet, das Signal zu empfangen, und dazu konfiguriert, das Signal auszuwerten. Beispielsweise kann die Sensor-Empfänger-Vorrichtung eine Software umfassen, die das Signal separiert, d.h. von anderen empfangenen unterscheidet und der mit dem Signal assoziierten physikalischen Größe zuordnet.

Bei einer Ausführungsform kann es vorgesehen sein, dass das Signal eine vorgebbare, vorzugsweise konstante Frequenz aufweist. D.h., Sensor-Sender-Vorrichtung kann so eingestellt werden, dass sie das Signal einer vorbestimmten Frequenz und/oder eins vorbestimmten/definierten Musters, z.B. gepulst, aussendet (Niederfrequent, ggf. Vibration, Eigenfrequenz vom Gehäuse der Maschine).

Es kann zweckmäßig sein, wenn die Frequenz des Signals außerhalb jener Frequenzen liegt, die durch die Maschine selbst im Betrieb erzeugt werden. Dabei handelt es sich insbesondere um akustische Frequenzen, die durch verschiedene Vibrationen der Maschine zustande kommen können.

Bei einer Ausführungsform kann es vorgesehen sein, dass das Signal eine vorbestimmte, beispielsweise konstante Amplitude aufweisen kann.

Bei einer Ausführungsform kann es vorgesehen sein, dass das Signal ein Signal in Form von Schallwellen, beispielsweise Ultraschall oder ein akustisches Signal ist.

Bei einer Ausführungsform kann es vorgesehen sein, dass die Sensor-Sender-Vorrichtung von der Sensor-Empfänger-Vorrichtung baulich getrennt ausgebildet ist.

Bei einer Ausführungsform kann es vorgesehen sein, dass die Sensor-Empfänger-Vorrichtung eingerichtet ist, über Funk mit mindestens einem Cloud-Dienst zu kommunizieren und die Überschreitung des Schwellenwerts an den Cloud-Dienst zu melden.

Bei einer Ausführungsform kann es vorgesehen sein, dass die Schaltung der Sensor-Sender-Vorrichtung eine elektrische bzw. elektronische Schaltung ist.

Bei einer Ausführungsform kann es vorgesehen sein, dass die Schaltung einen Widerstand umfasst, dessen Wert von dem Wert der physikalischen, mit der Maschine assoziierten Messgröße abhängt.

Bei einer Ausführungsform kann es vorgesehen sein, dass die Schaltung einen als elektronisches Bauelement ausgeführten Signalgeber umfasst.

Bei einer Ausführungsform kann es vorgesehen sein, dass der Signalgeber als ein Piezo-Summer ausgebildet ist. Der Piezo-Summer kann beispielsweise aktiv oder passiv sein.

Bei einer Ausführungsform kann es vorgesehen sein, dass die Schaltung einen Transistor, insbesondere einen Feldeffekttransistor - FET, beispielsweise einen Metall-Oxid-Halbleiter-Feldeffekttransistor - MOSFET - umfasst.

Die Sensor-Sender-Vorrichtung kann eine Stromquelle umfassen. Die Stromquelle dient dazu, den Signalgeber mit Strom zu versorgen, damit dieser das Signal aussenden kann.

Bei einer Ausführungsform kann es vorgesehen sein, dass der Signalgeber über Energy-Harvesting-Technologien wie Thermoelektrik oder Vibration, oder über Leistungsabgriff in dem Stromanschlussbereich, insbesondere im Klemmbrettkasten betrieben ist bzw. wird.

Bei einer Ausführungsform kann es vorgesehen sein, dass die Stromquelle eine Batterie, beispielsweise eine Knopfbatterie ist.

Bei einer Ausführungsform kann es vorgesehen sein, dass die physikalische Messgröße Temperatur, Vibrationen in einem Lager der Maschine, oder Strom ist.

Bei einer Ausführungsform kann es vorgesehen sein, dass, wenn die physikalische Messgröße eine Spannung ist, der Widerstand eine Schicht umfasst, die derart ausgebildet ist, dass bei Überspannungen Teilentladungen in der Schicht auftreten, wodurch einen Widerstandswert der Schicht vergrößert wird.

Die Aufgabe wird außerdem mit einer elektrischen, beispielsweise rotatorischen Maschine, insbesondere mit einem Niederspannungsmotor dadurch gelöst, dass die Maschine ein Gehäuse, einen von außen der Maschine zugänglichen Stromanschlussbereich (zum Anschließen der Maschine an Strom) und ein vorgenanntes Sensorsystem umfasst, wobei die beispielsweise autarke Sensor-Empfänger-Vorrichtung außen am Gehäuse der Maschine angebracht (beispielsweise befestigt, insbesondere angeklebt oder angeklemmt) ist, wobei die Sensor-Sender-Vorrichtung in dem Stromanschlussbereich angeordnet (beispielsweise befestigt) ist.

Weitere Merkmale, Eigenschaften und Vorteile der vorliegenden Erfindung ergeben sich aus der nachfolgenden Beschreibung unter Bezugnahme auf die beiliegenden Figuren. Darin zeigen schematisch:
- FIG 1: ein Niederspannungsmotor mit einem Sensorsystem,
- FIG 2: eine Sensor-Sender-Vorrichtung,

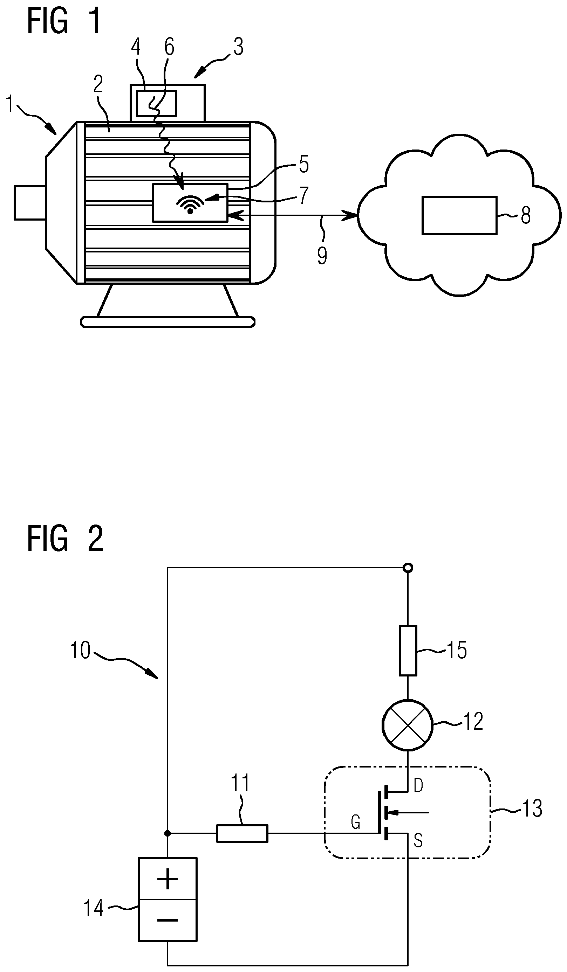

FIG 1 zeigt einen Niederspannungsmotor 1. Der Niederspannungsmotor 1 weist ein Gehäuse 2 auf. Am Gehäuse 2 ein Stromanschlussbereich 3 zu erkennen. Der Stromanschlussbereich 3 ist von außen des Niederspannungsmotors 1 zugänglich und dient zum Anschließen des Niederspannungsmotors 1 an Strom, beispielsweise an ein Versorgungsnetz, z.B. über eine Versorgungseinheit (Umrichter, insbesondere Frequenzumrichter).

Der Stromanschlussbereich 3 ist vorliegend in Form eines Klemmbrettkastens ausgeführt. Der Stromanschlussbereich 3 ist also jener Bereich des Niederspannungsmotors 1, durch den Wicklungsanschlüsse, beispielsweise mittels eines Klemmbretts, zugänglich sind. In dem Stromanschlussbereich 3 - hier in dem Klemmbrettkasten - ist eine Sensor-Sender-Vorrichtung 4 angeordnet. Beabstandet von der Sensor-Sender-Vorrichtung 4 ist eine beispielsweise autarke Sensor-Empfänger-Vorrichtung 5 außen am Gehäuse 2 des Niederspannungsmotors 1 befestigt.

Die Sensor-Sender-Vorrichtung 4 ist dazu ausgebildet, zumindest eine physikalische, mit dem Niederspannungsmotors 1 assoziierte Messgröße unmittelbar zu erfassen. Diese Messgröße kann beispielsweise die Spannung oder die Temperatur sein. Wenn die Messgröße einen vorbestimmten Schwellenwert überschreitet, sendet die Sensor-Sender-Vorrichtung 4 zumindest ein Signal 6 aus. Das Signal 6 ist somit ereignisgetriggert und insofern mit der erfassten Messgröße assoziiert, als es nur dann ausgesandt wird, wenn der vorgenannte Schwellenwert überschritten wird. Die Sensor-Sender-Vorrichtung 4 kann so eingestellt werden, dass sie das Signal 6 einer bestimmten Frequenz und/oder eines bestimmten Musters aussendet, die und/oder das sich von typischen Signalfrequenzen und/oder - mustern des Niederspannungsmotors 1 unterscheiden/unterscheidet. Das Signal 6 kann auch eine vorbestimmte, beispielsweise konstante Amplitude aufweisen.

Die Sensor-Sender-Vorrichtung 4 ist von der beispielsweise autarken Sensor-Empfänger-Vorrichtung 5 baulich getrennt ausgebildet. Die Sensor-Empfänger-Vorrichtung 5 kann insofern autark sein, als sie ohne direkte physikalische Verbindung externe bzw. sekundäre Messgrößen des Niederspannungsmotors 1 aufzeichnet und diese per Funk 7 weitergeben kann. Insbesondere ist die Sensor-Empfänger-Vorrichtung 5 mit keiner anderen Vorrichtung durch Kabel verbunden. Die Sensor-Empfänger-Vorrichtung 5 wird für gewöhnlich von einer in der Sensor-Empfänger-Vorrichtung 5 befindlichen Batterie gespeist. Diese Art von Sensor-Empfänger-Vorrichtungen ist im Stand der Technik allgemein bekannt. Oft werden diese als "SmartBox" bezeichnet.

Vorliegend ist die Sensor-Sender-Vorrichtung 4 derart weitergebildet, dass sie das Signal 6 empfangen kann und die Überschreitung des Schwellenwertes bei der mit dem Signal assoziierten physikalischen Größe melden kann.

Beispielsweise kann die Sensor-Empfänger-Vorrichtung 5 dazu eingerichtet sein, über Funk 7, beispielsweise WLAN, mit mindestens einem Cloud-Dienst 8 zu kommunizieren 9 und die Überschreitung des Schwellenwerts an den Cloud-Dienst 8 zu melden.

Das Signal 6 kann beispielsweise ein akustisches Signal sein. Das Signal 6 kann auch ein anderes Signal in Form von Schallwellen, z.B. ein Ultraschall-Signal sein.

Es kann vorgesehen sein, dass die Sensor-Sender-Vorrichtung 4 eine Schaltung, beispielsweise eine elektrische bzw. elektronische Schaltung 10 umfasst.

Bezugnehmend auf FIG 2, die ein Beispiel der Schaltung 10 veranschaulicht, kann erkannt werden, dass die Schaltung 10 einen Widerstand 11 umfassen kann. Der Widerstand 11 hat keinen festen Widerstandswert. Der Wert des Widerstands 11 verändert sich abhängig von dem Wert der physikalischen, mit dem Niederspannungsmotor 1 assoziierten Messgröße. Eine unmittelbare Veränderung des Widerstandswerts des Widerstands 11 abhängig von der physikalischen Größe bedeutet, dass die Sensor-Sender-Vorrichtung 4 unmittelbar an den Niederspannungsmotor angebunden ist und die physikalische Größe unmittelbar misst bzw. den primären Effekt dieser Größe misst.

Wenn die physikalische Messgröße eine Spannung ist, kann es zweckmäßig sein, wenn der Widerstand 11 eine Schicht (hier nicht gezeigt) umfasst, die derart ausgebildet ist, dass bei Überspannungen im Niederspannungsmotor 1 Teilentladungen in der Schicht auftreten, wodurch der Widerstandswert der Schicht vergrößert wird.

Eine solche Schicht ist beispielsweise aus der Anmeldung EP 3 505 943 A1 der Anmelderin bekannt. Diese kann beispielsweise in dem Klemmbrettkasten 3 des Niederspannungsmotors 1 angeordnet werden und eignet sich zum Nachweisen einer elektrischen Überspannung zwischen zwei elektrischen Leitern, beispielsweise Wicklungen im Klemmbrettkasten 3. Die Schicht umfasst beispielsweise einen aus einem elektrisch isolierenden Trägermaterial gefertigten Leiterbahnträger und wenigstens zwei voneinander beabstandet auf dem Leiterbahnträger aufgebrachte Leiterbahnen. Zum Erfassen der Überspannung zwischen zwei elektrischen Leitern soll jeder elektrische Leiter mit wenigstens einer der Leiterbahnen elektrisch verbunden, wobei keine Leiterbahn mit beiden elektrischen Leitern elektrisch verbunden ist, und die Leiterbahnen derart ausgebildet und angeordnet sind, dass eine (vorgegebene) Überspannung zwischen den elektrischen Leitern eine den elektrischen Widerstand der ersten Leiterbahn ändernde Teilentladung zwischen der ersten Leiterbahn und einer Leiterbahn, die mit einem der beiden elektrischen Leiter elektrisch verbunden ist, bewirkt. Übersteigt der elektrische Widerstandswert der ersten Leiterbahn einen vorbestimmten Schwellenwert, wird ein Signal 6 ausgelöst.

Die erste Leiterbahn kann somit als Widerstand 11 verwendet werden.

Weitere Details über die Schicht können der Anmeldung EP 3 505 943 A1, Absätze [0022] bis [0048], Fig 1-4 und insbesondere Absätze [0022] bis [0035], Fig 1 und 2 entnommen werden.

Mit einem solchen Widerstand 11 können Überspannungen und Spannungspulse im Klemmbrettkasten 3 aufgezeigt werden. D.h. es wird keine Messung jeder einzelnen Überspannung aufgezeigt, sondern eine über die Zeit integrierte Überspannungsaktivität detektiert.

Die Schicht kann beispielsweise als eine Verbundwerkstoff-Lackschicht ausgeführt sein. Die Schicht ist kostengünstig. Sie kann beispielsweise zwischen den Phasen und Erde im Klemmbrettkasten 3 eingelegt werden.

Durch eine geeignete geometrische Struktur dieser Schicht und definierten Leiterbahnen treten im Falle von Überspannungen gezielte Teilentladungen in der Schicht auf, welche diese zunehmend intrinsisch verändern. Durch irreversible Oxidation der keramischen Füllstoffpartikel (Verarmungsrandschichten der Zinnoxid-Partikel als Füllstoffe in der Kunststoffmatrix) kann der Widerstand 11 irreversibel um mehrere Größenordnungen ansteigen und somit als Messgröße für die elektrische Beanspruchung über die Zeit genutzt werden.

Um Signale 6 zu erzeugen kann die Sensor-Sender-Vorrichtung 4 einen Signalgeber 12 aufweisen.

In FIG 2 ist der Signalgeber 12 als Teil der Schaltung 10 gezeigt. Der Signalgeber 12 kann beispielsweise als ein Piezo-Summer ausgebildet sein.

Darüber hinaus ist der FIG 2 zu entnehmen, dass die Schaltung 10 einen Transistor in Form eines Metall-Oxid-Halbleiter-Feldeffekttransistors 13 - kurz MOSFET - mit den Anschlüssen: Gate (Gatter) G, Source (Quelle) S und Drain (Abfluss) D umfassen kann. Der Widerstand 11 kann beispielsweise über den Gate-Anschluss G, vorzugsweise unmittelbar an den Gate-Anschluss G angeschlossen sein und somit die Öffnung zwischen dem Source-Anschluss S und dem Gate-Anschluss G steuern. Dies kann je nach Schaltung des MOSFET 13 in beide Richtungen - also Durchgang, wenn hochohmig oder niederohmig - erfolgen.

Der Signalgeber 12 kann beispielsweise unmittelbar an den Drain-Anschluss D angeschlossen sein.

Die Sensor-Sender-Vorrichtung 4 kann eine Stromquelle umfassen. Die Stromquelle dient dazu, den Signalgeber 12 mit Strom zu versorgen, damit dieser das Signal 6 aussenden kann.

FIG 2 lässt erkennen, dass die Stromquelle als eine Batterie 14 ausgebildet sein kann und an den Signalgeber 12 über den MOSFET 13 angeschlossen sein kann (über Source-/Drain-Anschluss S/D).

Ein weiteres Beispiel der physikalischen Messgröße ist die Temperatur. Der Niederspannungsmotor 1 kann beispielsweise einen Temperaturfühler aufweisen, der beispielsweise in dem Klemmbrettkasten 3 endet. Der Temperaturfühler kann beispielsweise als ein Widerstandsthermometer (RTD engl. Resistance Temperature Detector), z.B. vom Typ PT 100 oder PT 1000 ausgeführt sein. Dadurch können die jeweiligen Temperaturen im Motor gemessen werden.

Der Widerstand 11 kann also als ein Temperaturfühler ausgeführt sein. Dadurch können Übertemperaturen in dem Motor 1, beispielsweise in der Nut und im Wickelkopf des Motors 1 *in-situ* über das Signal 6 gemeldet werden können.

Außerdem stellt dies einer Vereinfachung der Temperaturmessung. Die Messwertanalyse erfolgt bislang durch einen Servicetechniker und das aktive Anklemmen und Auslesen der Werte im Betrieb. Dies ist im Vergleich zu der vorgeschlagenen Methode, bei welcher die Überschreitung eines vorgegebenen Temperatur-Schwellenwertes durch Aussenden des Signals 6 gemeldet wird, viel aufwändiger.

Außerdem ist es denkbar, weitere zustandsrelevante Messgrößen, wie Vibrationen in einem Lager des Niederspannungsmotors 1 detektiert werden, welche auf die Güte der Schmierstoffe und somit auf reduzierte Lebensdauer des Lagers hinweisen. Ebenso ist eine elektrische Auswertung der Ströme möglich, um zu bestimmen, ob der Niederspannungsmotor 1 im idealen Nennpunkt und damit im Bereich des höchsten Wirkungsgrades betrieben wird. Eine Assistenz des Benutzers (z.B. durch wiederholtes Benachrichtigen) oder eine direkte, intelligente Optimierung könnte somit den Verbrauch und damit die Ressourceneffizienz erhöhen sowie die Lebensdauer des Motors 1 verlängern.

Der Widerstand 15 bezeichnet schematisch einen Widerstand der Verdrahtung der Schaltung 10 und/oder den inneren Widerstand des Signalgebers 12.

Zusammenfassend ist in der vorliegenden Offenbarung eine Möglichkeit gezeigt, Messgrößen, beispielsweise Temperatur, oben beschrieben TE (Teilentladungen) Aktivität, über einen beispielsweise akustischen Signalgeber an die SmartBox anzukoppeln. Hierbei kann ein handelsüblicher Piezosummer (Stückpreis im Cent-Bereich) zum Einsatz kommen und mittels einer Batterieknopfzelle (oder ggf. über Energy-Harvesting-Technologien wie Thermoelektrik oder Vibration, oder über Leistungsabgriff im Klemmbrett) dauerhaft betrieben werden.

Durch die beispielsweise akustische Ankopplung an die SmartBox ist eine besonders kostengünstige Messung und Übertragung der Messgröße möglich.

Die Übertragung von Zustandssignalen an eine vorhandene Kopplungselektronik (SmartBox) ist über verschiedene physikalische Mechanismen möglich. Idealerweise wird ein Mechanismus verwendet, welcher ohnehin schon als Detektor in der Kopplungselektronik vorhanden ist, wie Schall. Es können verschiedene Frequenzen und Muster genutzt werden (Niederfrequent, ggf. Vibration, Eigenfrequenz vom Gehäuse) bis hin zu Ultraschall.

Die Aufgabe dieser Beschreibung besteht lediglich darin, veranschaulichende Beispiele bereitzustellen und weitere Vorteile und Besonderheiten dieser Erfindung anzugeben. Somit kann sie nicht als Einschränkung des Anwendungsgebiets der Erfindung beziehungsweise der in den Ansprüchen beanspruchten Patentrechte interpretiert werden.

## Patentansprüche

1. Sensorsystem für eine elektrische Maschine (1) umfassend eine Sensor-Sender-Vorrichtung (4) und eine Sensor-Empfänger-Vorrichtung (5), wobei die Sensor-Sender-Vorrichtung (4) und die Sensor-Empfänger-Vorrichtung (5) außen an der Maschine (1) anbringbar sind, wobei
die Sensor-Sender-Vorrichtung (4) dazu ausgebildet ist, zumindest eine physikalische, mit der Maschine (1) assoziierte Messgröße zu erfassen und, wenn die Messgröße einen vorbestimmten Schwellenwert überschreitet, zumindest ein mit der Messgröße assoziiertes Signal (6) auszusenden, wobei die Sensor-Empfänger-Vorrichtung (5) dazu eingerichtet ist, das Signal (6) zu empfangen und die Überschreitung des Schwellenwerts zu melden, **dadurch gekennzeichnet, dass**
die Sensor-Sender-Vorrichtung (4) dazu ausgebildet ist, in einem Stromanschlussbereich (3) der elektrischen Maschine (1) angeordnet zu werden, und die Sensor-Empfänger-Vorrichtung (5) dazu eingerichtet ist, außen an der Maschine (1) befestigt zu werden, wobei die zumindest eine physikalische Messgröße Spannung ist, und die Sensor-Sender-Vorrichtung ausgebildet ist, Überspannungen in der elektrischen Maschine (1) zu erfassen, wobei
die Sensor-Sender-Vorrichtung (4) eine Schaltung (10) umfasst, wobei
die Schaltung (10) einen Widerstand (11) umfasst, wobei der Widerstand (11) eine Schicht umfasst, die derart ausgebildet ist, dass bei den Überspannungen in der elektrischen Maschine (1) Teilentladungen in der Schicht auftreten, wodurch sich der Wert des Widerstands (11) vergrößert.

2. System nach Anspruch 1, wobei die Sensor-Sender-Vorrichtung (4) von der Sensor-Empfänger-Vorrichtung (5) baulich getrennt ausgebildet ist.

3. System nach Anspruch 1 oder 2, wobei die Sensor-Empfänger-Vorrichtung (5) eingerichtet ist, über Funk (7) mit mindestens einem Cloud-Dienst (8) zu kommunizieren (9) und die Überschreitung des Schwellenwerts an den Cloud-Dienst (8) zu melden.

4. System nach einem der Ansprüche 1 bis 3, wobei das Signal (6) ein Signal in Form von Schallwellen, beispielsweise Ultraschall oder ein akustisches Signal ist.

5. System nach einem der Ansprüche 1 bis 4, wobei das Signal (6) eine vorgebbare, vorzugsweise konstante Frequenz aufweist.

6. System nach einem der Ansprüche 1 bis 5, wobei die Sensor-Sender-Vorrichtung (4) als eine Schaltung (10) ausgebildet ist.

7. System nach einem der Ansprüche 1 bis 6, wobei die Schaltung (10) einen als elektronisches Bauelement ausgeführten Signalgeber (12) umfasst.

8. System nach Anspruch 7, wobei der Signalgeber (12) als ein Piezo-Summer ausgebildet ist.

9. System nach Anspruch 7 oder 8, wobei der Signalgeber (12) ausgebildet ist, über Energy-Harvesting-Technologien, beispielsweise über Thermoelektrik oder Vibration, oder über Leistungsabgriff in dem Stromanschlussbereich (3) betrieben zu werden.

10. System nach einem der Ansprüche 1 bis 9, wobei die Schaltung (10) einen Transistor, insbesondere einen Feldeffekttransistor, beispielsweise einen Metall-Oxid-Halbleiter-Feldeffekttransistor (13) umfasst.

11. System nach einem der Ansprüche 1 bis 10, wobei die Sensor-Sender-Vorrichtung (4) eine Stromquelle umfasst.

12. System nach Anspruch 11, wobei die Stromquelle als eine Batterie (14), beispielsweise eine Knopfbatterie ausgebildet ist.

13. System nach einem der Ansprüche 1 bis 12, wobei die physikalische Messgröße Temperatur, Vibrationen in einem Lager der Maschine (1), oder Strom ist.

14. System nach Anspruch 13, wobei der Wert des Widerstands (11) von dem Wert der physikalischen Messgröße abhängt.

15. Elektrische Maschine umfassend ein Gehäuse (2), einen von außen der Maschine (1) zugänglichen Stromanschlussbereich (3) und ein Sensorsystem nach einem der Ansprüche 1 bis 14, wobei die Sensor-Empfänger-Vorrichtung (5) außen am Gehäuse (2) der Maschine angebracht ist, wobei die Sensor-Sender-Vorrichtung (4) in dem Stromanschlussbereich (3) angeordnet ist.

16. Maschine nach Anspruch 15, wobei die Maschine als ein Niederspannungsmotor ausgebildet ist.

## Claims

1. Sensor system for an electric machine (1) comprising a sensor/transmitter apparatus (4) and a sensor/receiver apparatus (5), wherein the sensor/transmitter apparatus (4) and the sensor/receiver apparatus (5) can be attached externally on the machine (1), wherein
the sensor/transmitter apparatus (4) is designed to detect at least one physical measurement variable associated with the machine (1) and, if the measurement variable exceeds a previously defined threshold value, to transmit at least one signal (6) associated with the measurement variable, wherein the sensor/receiver apparatus (5) is designed to receive the signal (6) and to provide notification that the threshold value has been exceeded, **characterised in that**
the sensor/transmitter apparatus (4) is designed to be arranged in a power connection area (3) of the electric machine (1), and the sensor/receiver apparatus (5) is designed to be attached to the outside of the machine (1), wherein the at least one physical measurement variable is voltage, and the sensor/transmitter apparatus is designed to detect overvoltage in the electric machine (1), wherein
the sensor/transmitter apparatus (4) comprises a circuit (10), wherein
the circuit (10) comprises a resistor (11), wherein
the resistor (11) comprises a layer which is designed in such a way that partial discharges occur in the layer during the overvoltage in the electric machine (1), whereby the value of the resistor (11) increases.

2. System according to claim 1, wherein the sensor/transmitter apparatus (4) is structurally separate from the sensor/receiver apparatus (5).

3. System according to claim 1 or 2, wherein the sensor/receiver apparatus (5) is designed to communicate (9) via radio (7) with at least one cloud service (8) and to report the exceeding of the threshold value to the cloud service (8).

4. System according to one of claims 1 to 3, wherein the signal (6) is a signal in the form of sound waves, for example ultrasound or an acoustic signal.

5. System according to one of claims 1 to 4, wherein the signal (6) has a predeterminable, preferably constant frequency.

6. System according to one of claims 1 to 5, wherein the sensor/transmitter apparatus (4) is designed as a circuit (10).

7. System according to one of claims 1 to 6, wherein the circuit (10) comprises a signal transmitter (12) designed as an electronic component.

8. System according to claim 7, wherein the signal transmitter (12) is designed as a piezo buzzer.

9. System according to claim 7 or 8, wherein the signal transmitter (12) is designed to be operated via energy harvesting technologies, for example via thermoelectrics or vibration, or via power tapping in the power connection area (3).

10. System according to one of claims 1 to 9, wherein the circuit (10) comprises a transistor, in particular a field effect transistor, for example a metal-oxide semiconductor field effect transistor (13).

11. System according to one of claims 1 to 10, wherein the sensor/transmitter apparatus (4) comprises a power source.

12. System according to claim 11, wherein the power source is designed as a battery (14), for example a button battery.

13. System according to one of claims 1 to 12, wherein the physical measurement variable is temperature, vibrations in a bearing of the machine (1), or current.

14. System according to claim 13, wherein the value of the resistor (11) depends on the value of the physical measurement variable.

15. Electric machine comprising a housing (2), a power connection area (3) accessible from the outside of the machine (1) and a sensor system according to one of the claims 1 to 14, wherein the sensor/receiver apparatus (5) is attached on the outside of the housing (2) of the machine, wherein the sensor/transmitter apparatus (4) is arranged in the power connection area (3).

16. Machine according to claim 15, wherein the machine is designed as a low voltage motor.

## Revendications

1. Système de capteur pour une machine (1) électrique comportant un dispositif (4) capteur-émetteur et un dispositif (5) capteur-récepteur, dans lequel le dispositif (4) capteur-émetteur et le dispositif (5) capteur-récepteur peuvent être montés à l'extérieur sur la machine (1), dans lequel
le dispositif (4) capteur-émetteur est réalisé pour détecter au moins une grandeur de mesure physique, associée à la machine (1) et, si la grandeur de mesure dépasse une valeur déterminée à l'avance, pour émettre au moins un signal (6) associé à la grandeur de mesure, le dispositif (5) capteur-récepteur étant conçu pour recevoir le signal (6) et pour indiquer le dépassement de la valeur seuil, **caractérisé**
**en ce que** le dispositif (4) capteur-émetteur est réalisé pour être monté dans une zone (3) de raccordement de courant de la machine (1) électrique, et le dispositif (5) capteur-récepteur est conçu pour être fixé à l'extérieur à la machine (1), dans lequel la au moins une grandeur de mesure physique est de la tension, et le dispositif capteur-émetteur est réalisé pour détecter des surtensions dans la machine (1) électrique, dans lequel
le dispositif (4) capteur-émetteur comporte un circuit (10),
dans lequel le circuit (10) comporte une résistance (11), dans lequel la résistance (11) comporte une couche, qui est réalisée de telle manière que, dans le cas des surtensions dans la machine (1) électrique, des décharges partielles apparaissent dans la couche, ce qui augmente la valeur de la résistance (11).

2. Système suivant la revendication 1, dans lequel le dispositif (4) capteur-émetteur est réalisé de manière séparée du point de vue de la construction du dispositif (5) capteur-récepteur.

3. Système suivant la revendication 1 ou 2, dans lequel le dispositif (5) capteur-récepteur est conçu pour communiquer (9) par radio (7) avec au moins un service (8) en nuage, et pour indiquer le dépassement de la valeur seuil au service (8) en nuage.

4. Système suivant l'une des revendications 1 à 3, dans lequel le signal (6) est un signal en forme d'ondes sonores, par exemple de l'ultrason ou un signal acoustique.

5. Système suivant l'une des revendications 1 à 4, dans lequel le signal (6) comporte une fréquence pouvant être donnée à l'avance, de préférence constante.

6. Système suivant l'une des revendications 1 à 5, dans lequel le dispositif (4) capteur-émetteur est réalisé en un circuit (10).

7. Système suivant l'une des revendications 1 à 6, dans lequel le circuit (10) comporte un transmetteur (12) de signal réalisé en composant électronique.

8. Système suivant la revendication 7, dans lequel le transmetteur (12) de signal est réalisé en vibreur piézoélectrique.

9. Système suivant la revendication 7 ou 8, dans lequel le transmetteur (12) de signal est réalisé pour fonctionner par l'intermédiaire de technologies energy-harvesting, par exemple par l'intermédiaire de la thermoélectricité ou de la vibration, ou par l'intermédiaire de prises de puissance dans la zone (3) de raccordement de courant.

10. Système suivant l'une des revendications 1 à 9, dans lequel le circuit (10) comprend un transistor, notamment un transistor à effet de champ, par exemple un transistor (13) à effet de champ semiconducteur-métal-oxyde.

11. Système suivant l'une des revendications 1 à 10, dans lequel le dispositif (4) capteur-émetteur comporte une source de courant.

12. Système suivant la revendication 11, dans lequel la source de courant est réalisée en batterie (14), par exemple en batterie bouton.

13. Système suivant l'une des revendications 1 à 12, dans lequel la grandeur de mesure physique est la température, des vibrations dans un palier de la machine (1) ou du courant.

14. Système suivant la revendication 13, dans lequel la valeur de la résistance (11) dépend de la valeur de la grandeur de mesure physique.

15. Machine électrique comprenant un carter (2), une zone (3) de raccordement de courant accessible de l'extérieur de la machine (1) et un système de capteur suivant l'une des revendications 1 à 14, dans lequel le dispositif (5) capteur-récepteur est monté à l'extérieur sur le carter (2) de la machine, dans lequel le dispositif (4) capteur-émetteur est monté dans la zone (3) de raccordement de courant.

16. Machine suivant la revendication 15, dans lequel la machine est réalisée en moteur basse tension.
